# EUROPEAN PATENT APPLICATION

(11) **EP 4 417 739 A1**
(43) Date of publication of application: **21.08.2024**
(21) Application number: 21960703.3
(22) Date of filing: 22.12.2021
(51) Int. Cl.: C30B 29/36, C04B 35/577, C30B 1/02

(54) **RARE EARTH-CONTAINING SIC SUBSTRATE AND SIC COMPOSITE SUBSTRATE**

(30) Priority: 12.10.2021 JP 2021167477
(71) Applicant: NGK Insulators, Ltd., Nagoya city, Aichi 467-8530 (JP)
(72) Inventor: MIYAKAZE, Risa, Nagoya-City, Aichi 467-8530 (JP); MATSUSHIMA, Kiyoshi, Nagoya-City, Aichi 467-8530 (JP); YOSHIKAWA, Jun, Nagoya-City, Aichi 467-8530 (JP)
(74) Representative: Müller-Boré & Partner Patentanwälte PartG mbB
(86) International application number: PCT/JP2021/047648
(87) International publication number: WO 2023/062850

(57) **Abstract**

Provided is a rare earth-containing SiC substrate that can reduce breaking and cracks during the processing of the substrate. This rare earth-containing SiC substrate includes a biaxially oriented SiC layer wherein a ratio of a concentration C_{B} of B to a concentration C_{RE} of a rare earth element, C_{B}/C_{RE}, is 1.0 × 10⁻² to 1.0 × 10⁵.

## Description

### TECHNICAL FIELD

The present invention relates to a rare earth-containing SiC substrate and a SiC composite substrate.

### BACKGROUND ART

SiC (silicon carbide) has attracted attention as a wide bandgap material capable of controlling large voltage and large electric power with low loss. In recent years in particular, power semiconductor devices using SiC materials (SiC power devices) are superior to those using Si semiconductors in terms of downsizing, low power consumption, and high efficiency, and therefore are expected to be utilized in various applications. For example, by adopting the SiC power devices, a converter, an inverter, an in-vehicle charger, and the like for an electric vehicle (EV) or a plug-in hybrid vehicle (PHEV) can be downsized, making it possible to improve efficiency.

To produce a SiC power device, a SiC single crystal needs to be epitaxially grown on a SiC single crystal substrate. It is reported that in a liquid phase growth method known as a method for growing a SiC single crystal, Y is suitably used in order to improve carbon solubility of a solvent that is used as a liquid phase and increase the growth rate. For example, Patent Literature 1 (JP2019-19037A) discloses a method for manufacturing a SiC single crystal, in which a crystal growth surface of a SiC seed crystal is brought into contact with a solution containing Si, Y, and C to grow a crystal of SiC on this crystal growth surface and states that both improvement in crystal growth rate of a SiC single crystal and reduction in the concentration of metal impurities (Cr and Ti) can be achieved. This literature also mentions that the concentration of Y in the resultant SiC single crystal can be 1 × 10¹⁴ to 5 × 10¹⁵ /cm³. Further, Patent Literature 2 (JP2012-46384A) discloses a method for manufacturing a SiC single crystal by a solution growth method utilizing a melt containing 60 at% or more of a rare earth element. This literature mentions Sc, Y, La, Ce, Pr, Nd, Pm, Sm, Eu, Gd, Tb, Dy, Ho, Er, Tm, Yb, and Lu as examples of the rare earth element and states that Dy is preferred among others.

### CITATION LIST

### PATENT LITERATURE

Patent Literature 1: JP2019-19037A
Patent Literature 2: JP2012-46384A

### SUMMARY OF INVENTION

As described above, the quality of a SiC single crystal can be improved by using a rare earth element, but only the use of a rare earth element is not enough. For example, when only a rare earth element (for example, Y) is added to a SiC single crystal, strain occurs in the crystal due to a change in lattice constant, macrodefects such as solvent inclusion and different polymorphic crystal forms occur because macrosteps form a giant macrostep during crystal growth, and thereby breaking and cracks may frequently occur to a SiC substrate during processing such as grinding or polishing.

The present inventors have now discovered that by allowing a rare earth-containing SiC substrate to contain boron (B) at a predetermined concentration ratio, breaking and cracks during the processing of the substrate can be reduced.

Therefore, it is an object of the present invention to provide a rare earth-containing SiC substrate that can reduce breaking and cracks during the processing of the substrate.

According to an aspect of the present invention, there is provided a rare earth-containing SiC substrate comprising a biaxially oriented SiC layer wherein a ratio of a concentration C_{B} of B to a concentration C_{RE} of a rare earth element, C_{B}/C_{RE}, is 1.0 × 10⁻² to 1.0 × 10⁵.

According to another aspect of the present invention, there is provided a SiC composite substrate comprising:
a SiC single crystal substrate; and
the rare earth-containing SiC substrate on the SiC single crystal substrate.

### BRIEF DESCRIPTION OF DRAWINGS

Figure 1 is a longitudinal cross-sectional view of a SiC composite substrate 10.
Figure 2 is a diagram showing a process of manufacturing the SiC composite substrate 10.
Figure 3 is a conceptual diagram showing a configuration of an aerosol deposition (AD) apparatus 50.

### DESCRIPTION OF EMBODIMENTS

### Rare Earth-Containing SiC Substrate

A rare earth-containing SiC substrate according to the present invention comprises a biaxially oriented SiC layer comprising a rare earth element and boron (B). In the biaxially oriented SiC layer, the ratio of the concentration C_{B} of B to the concentration C_{RE} of the rare earth element, C_{B}/C_{RE}, is 1.0 × 10⁻² to 1.0 × 10⁵. By allowing the rare earth-containing SiC substrate (specifically, the biaxially oriented SiC layer) to contain boron (B) at a predetermined concentration ratio in this manner, breaking and cracks during the processing of the substrate can be reduced. Therefore, the rare earth-containing SiC substrate of the present invention can be manufactured and processed with a high yield.

As described above, the quality of a SiC single crystal can be improved by using a rare earth element, but when only a rare earth element (for example, Y) is added to a SiC single crystal, breaking and cracks frequently occur to a SiC substrate during processing such as grinding or polishing. In this respect, according to the present invention, such a problem can be solved conveniently. The mechanism is not necessarily certain, but it is considered as follows: not only the rare earth element but also B is present inside the substrate, thereby the strain in the SiC crystal is relaxed, and as a result, breaking and cracks during processing are reduced.

In the biaxially oriented SiC layer which the rare earth-containing SiC substrate of the present invention comprises, the ratio of the concentration C_{B} of B to the concentration C_{RE} of the rare earth element, C_{B}/C_{RE}, is 1.0 × 10⁻² to 1.0 × 10⁵. This C_{B}/C_{RE} is preferably 1.0 × 10° to 1.0 × 10⁴. By setting the concentration ratio as just described above, breaking and cracks during the processing of the substrate can be reduced more effectively.

The concentration C_{RE} of the rare earth element is preferably 3.0 × 10¹³ to 9.0 × 10¹⁵ atoms/cm³, and more preferably 1.0 × 10¹⁴ to 9.0 × 10¹⁵ atoms/cm³. The concentration C_{B} of B is preferably 4.5 × 10¹⁴ to 1.0 × 10¹⁸ atoms/cm³, and more preferably 1.0 × 10¹⁵ to 1.0 × 10¹⁸ atoms/cm³. By setting the concentrations of the rare earth element and B as just described above, breaking and cracks during the processing of the substrate can be reduced more effectively.

Examples of the rare earth element contained in the biaxially oriented SiC layer include Y, La, Ce, Pr, Nd, Pm, Sm, Eu, Gd, Tb, Dy, Ho, Er, Tm, Yb, Lu, Sc and combinations thereof. This rare earth element is preferably Y and/or Ce in view of reducing breaking and cracks, and more preferably Y.

The biaxially oriented SiC layer is preferably oriented in the c-axis direction and the a-axis direction. In addition, the rare earth-containing SiC substrate is preferably composed of the biaxially oriented SiC layer. The biaxially oriented SiC layer may be a SiC single crystal, a SiC polycrystal, or a mosaic crystal as long as the biaxially oriented SiC layer is oriented in the biaxial directions of the c-axis direction and the a-axis direction. The mosaic crystal refers to an aggregate of crystals not having clear grain boundaries but being such that the orientation directions of the crystals are slightly different from one or both of the c-axis and the a-axis. The method for evaluating the orientation is not particularly limited, but known analysis methods such as an EBSD (Electron Back Scatter Diffraction Patterns) method and an X-ray pole figure can be used. For example, when the EBSD method is used, inverse pole figure mapping of a surface (plate surface) of the biaxially oriented SiC layer or a section orthogonal to the plate surface is measured. When the following four conditions are satisfied in the resultant inverse pole figure mapping, the SiC layer can be defined as being biaxially oriented in an approximate normal direction and an approximate plate surface direction: (A) the SiC layer is oriented in a particular direction (the first axis) in an approximate normal direction of the plate surface; (B) the SiC layer is oriented in a particular direction (the second axis) in an approximate in-plate-surface direction, the direction orthogonal to the first axis; (C) tilt angles from the first axis are distributed within ±10°; and (D) tilt angles from the second axis are distributed within ±10°. In other words, when the four conditions are satisfied, the SiC layer is determined to be biaxially oriented along the c-axis and the a-axis. For example, when the approximate normal direction of the plate surface is oriented along the c-axis, the approximate in-plate-surface direction only needs to be oriented in a particular direction (for example, the a-axis) orthogonal to the c-axis. The biaxially oriented SiC layer only needs to be biaxially oriented in the approximate normal direction and the approximate in-plate-surface direction, but the approximate normal direction is preferably oriented along the c-axis direction. As a tilt angle distribution in the approximate normal direction and/or the approximate in-plate-surface direction is smaller, the mosaicity of the biaxially oriented SiC layer is smaller, and as the tilt angle distribution is closer to zero, the biaxially oriented SiC layer is closer to a single crystal. Therefore, in view of the crystallinity of the biaxially oriented SiC layer, the tilt angle distribution is preferably smaller in both the approximate normal direction and the approximate plate surface direction, more preferably, for example, ±5° or less, and further preferably ±3° or less.

### SiC Composite Substrate

The rare earth-containing SiC substrate of the present invention is preferably in the form of a SiC composite substrate. Specifically, according to a preferred aspect of the present invention, there is provided a SiC composite substrate comprising: a SiC single crystal substrate; and the above-described rare earth-containing SiC substrate on the SiC single crystal substrate. As just described above, when the SiC composite substrate comprises a rare earth-containing SiC substrate comprising a biaxially oriented SiC layer comprising a rare earth element and boron (B) at a predetermined concentration ratio, thereby breaking and cracks during the processing of the substrate can be reduced.

The SiC single crystal substrate is typically a layer composed of a SiC single crystal and has a crystal growth surface. The polytype, off angle, and polarity of the SiC single crystal are not particularly limited, but the polytype is preferably 4H or 6H, the off angle is preferably 0.1 to 12° from the [0001] axis of single crystal SiC, and the polarity is preferably the Si surface. More preferably, the polytype is 4H, the off angle is 1 to 5° from the [0001] axis of single crystal SiC, and the polarity is the Si surface.

The rare earth-containing SiC substrate of the present invention may be in the form of a self-supporting substrate consisting of a biaxially oriented SiC layer or may be in the form of a SiC composite substrate with a SiC single crystal substrate. Therefore, the biaxially oriented SiC layer may be finally separated from the SiC single crystal substrate as necessary. The separation of the SiC single crystal substrate may be performed by a known method and is not particularly limited. Examples of the known method include a method of separating the biaxially oriented SiC layer with a wire saw, a method of separating the biaxially oriented SiC layer by electro discharge machining, and a method of separating the biaxially oriented SiC layer utilizing laser. In an embodiment in which the biaxially oriented SiC layer is epitaxially grown on a SiC single crystal substrate, the biaxially oriented SiC layer may be installed on another support substrate after the SiC single crystal substrate is separated. The material of the another support substrate is not particularly limited and suitable one may be selected in view of physical properties of the material. In view of thermal conductivity for example, examples of the material include metal substrates such as a Cu substrate and ceramic substrates such as a SiC substrate and an AIN substrate.

### Method for Manufacturing SiC Composite Substrate

The SiC composite substrate comprising the rare earth-containing SiC substrate of the present invention can be preferably manufactured by (a) forming a predetermined orientation precursor layer on a SiC single crystal substrate, (b) subjecting the orientation precursor layer to heat treatment on the SiC single crystal substrate to convert at least a portion of the orientation precursor layer near the SiC single crystal substrate into a rare earth-containing SiC substrate (biaxially oriented SiC layer), and, optionally, (c) performing processing such as grinding or polishing to expose the surface of the biaxially oriented SiC layer. However, the method for manufacturing the SiC composite substrate is not limited as long as it is possible to obtain a SiC substrate comprising a rare earth element. For example, vapor phase methods such as CVD and a sublimation method may be adopted, or liquid phase methods such as a solution method may be adopted. The concentration of B in the biaxially oriented SiC layer can be controlled by adjusting the amount of boron or a boron compound (for example, boron carbide) to be added to the raw materials, calcining the raw materials, or vapor-depositing metal boron onto a SiC single crystal. According to such manufacturing methods, it is possible to preferably produce the rare earth-containing SiC substrate comprising a biaxially oriented SiC layer in which the concentration ratio between the rare earth element and B is controlled, and it is possible to effectively reduce breaking and cracks during the processing of the rare earth-containing SiC substrate or the SiC composite substrate using the rare earth-containing SiC substrate.

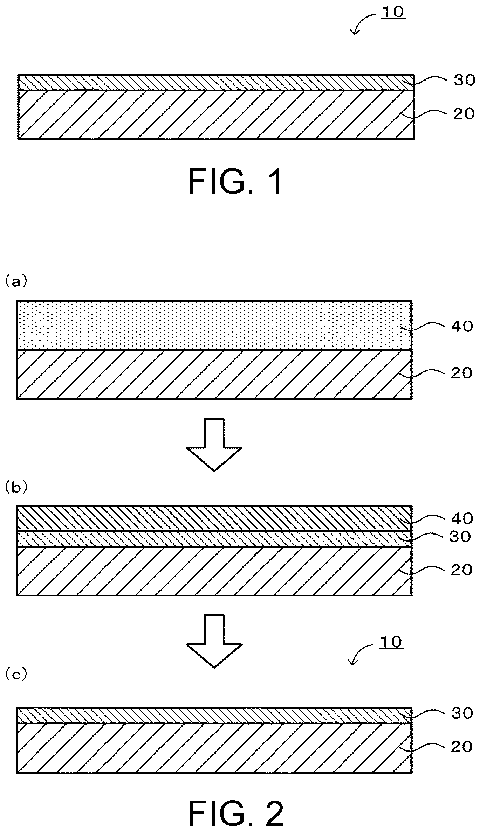

Hereinafter, a preferred method for manufacturing the SiC composite substrate will be described. Figure 1 is a longitudinal cross-sectional view of a SiC composite substrate 10 (a cross-sectional view obtained by cutting the SiC composite substrate 10 vertically along a plane including the central axis of the SiC composite substrate 10). Figure 2 is a diagram showing a process of manufacturing the SiC composite substrate 10.

As shown in Figure 1, the SiC composite substrate 10 of the present embodiment comprises: a SiC single crystal substrate 20; and a rare earth-containing SiC substrate 30 (corresponding to the rare earth-containing SiC substrate of the present invention) on the SiC single crystal substrate.

### (a) Process of Forming Orientation Precursor Layer (see Figure 2(a))

An orientation precursor layer 40 is made into the rare earth-containing SiC substrate (biaxially oriented SiC layer) 30 by heat treatment, which will be described later. In the process of forming the orientation precursor layer 40, the orientation precursor layer 40 is formed on a crystal growth surface of the SiC single crystal substrate 20.

As the method for forming the orientation precursor layer 40, a known method can be adopted. Examples of the method for forming the orientation precursor layer 40 include solid phase film deposition methods such as an AD (Aerosol Deposition) method and a HPPD (Hypersonic Plasma Particle Deposition) method, vapor phase film deposition methods such as a sputtering method, a vapor deposition method, a sublimation method, and various CVD (Chemical Vapor Deposition) methods, and liquid phase film deposition methods such as a solution growth method, and a method of directly forming the orientation precursor layer 40 on the SiC single crystal substrate 20 can be used. As the CVD method, for example, a thermal CVD method, a plasma CVD method, a mist CVD method, and a MO (Metal Organic) CVD method can be used. Further, it is also possible to use a method in which a polycrystalline substance previously produced by a sublimation method, any of various CVD methods, sintering, or the like is used as the orientation precursor layer 40, and the polycrystalline substance is placed on the SiC single crystal substrate 20. Alternatively, the method for forming the orientation precursor layer 40 may also be a method in which a green body of the orientation precursor layer 40 is preliminarily produced, and this green body is placed on the SiC single crystal substrate 20. Such an orientation precursor layer 40 may be tape green body produced by tape casting or a green compact produced by pressure forming such as uniaxial pressing.

In forming these orientation precursor layers 40, a rare earth compound is preferably contained in the raw materials for the orientation precursor layers 40. Examples of the rare earth compound include, but not particularly limited to, oxides, nitrides, carbides, and fluorides of at least one element among the above-described 17 rare earth elements. The rare earth compound is preferably an oxide of a rare earth element and more preferably an oxide of Y (yttrium oxide) or an oxide of Ce (cerium oxide). As described above, the concentration ratio between the rare earth element and B in the biaxially oriented SiC layer to be finally obtained can be controlled by, for example, adjusting the amount of boron or a boron compound (for example, boron carbide) to be added to the raw materials, calcining the raw materials, and vapor-depositing metal boron onto a SiC single crystal.

When any of various CVD methods, a sublimation method, a solution growth method, or the like is used in the method of directly forming the orientation precursor layer 40 on the SiC single crystal substrate 20, epitaxial growth may occur on the SiC single crystal substrate 20 without a heat treatment process, which will be described later, so that the rare earth-containing SiC substrate 30 may be deposited. However, the orientation precursor layer 40 is preferably not oriented, specifically is preferably an amorphous or non-oriented polycrystal, at the time of formation, and is preferably oriented using a SiC single crystal as a seed in the heat treatment process in a later stage. Thus, crystal defects that reach the surface of the rare earth-containing SiC substrate 30 can be effectively reduced. The reason for this is not certain, but it is considered that the solid phase orientation precursor layer once deposited causes rearrangement of the crystal structure using a SiC single crystal as a seed, and this may also have an effect in disappearance of crystal defects. Therefore, when any of various CVD methods, a sublimation method, a solution growth method, or the like is used, it is preferred to select conditions that do not cause epitaxial growth to occur in the process of forming the orientation precursor layer 40.

However, the method for forming the orientation precursor layer 40 is preferably a method of directly forming the orientation precursor layer 40 on the SiC single crystal substrate 20 by an AD method or any of various CVD methods, or a method of placing a polycrystalline substance on the SiC single crystal substrate 20, wherein the polycrystalline substance is separately produced by a sublimation method, any of various CVD methods, sintering, or the like. The use of these methods makes it possible to form the orientation precursor layer 40 in a relatively short time. The AD method is particularly preferred because a high-vacuum process is unnecessary, and the film deposition rate is relatively high. In the method using a previously produced polycrystalline substance as the orientation precursor layer 40, ingenuity such as making the surface of the polycrystalline substance sufficiently smooth in advance is necessary in order to enhance the adhesion between the polycrystalline substance and the SiC single crystal substrate 20. Therefore, the method of directly forming the orientation precursor layer 40 is preferred in view of cost. The method of placing a previously produced green body on the SiC single crystal substrate 20 is also preferred as a simple method, but the orientation precursor layer 40 is composed of a powder, and therefore a sintering process is necessary in the heat treatment process, which will be described later. Known conditions can be used in any of the methods, but hereinafter, description will be made on the method of directly forming the orientation precursor layer 40 on the SiC single crystal substrate 20 by an AD method or a thermal CVD method and the method of placing a previously produced green body on the SiC single crystal substrate 20.

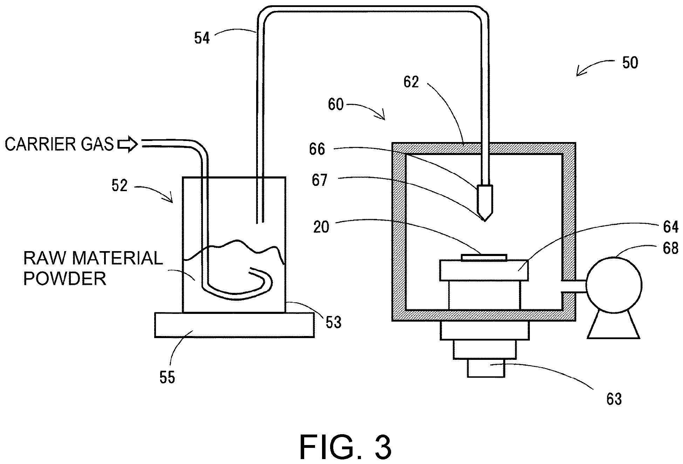

The AD method is a technique such that fine particles or fine particle raw materials are mixed with a gas to form aerosol, and this aerosol is jetted at a high speed from a nozzle to allow the aerosol to collide with a substrate to form a coat and has a characteristic that the coat can be formed at normal temperature. Figure 3 shows an example of a film deposition apparatus (AD apparatus) that is used in such an AD method. An AD apparatus 50 shown in Figure 3 is configured as an apparatus that is used in an AD method in which a raw material powder is jetted onto a substrate in an atmosphere where the air pressure is lower than the atmospheric pressure. This AD apparatus 50 comprises: an aerosol generation unit 52 that generates aerosol of a raw material powder containing raw material components; and a film deposition unit 60 that jets the raw material powder onto the SiC single crystal substrate 20 to form a film containing the raw material components. The aerosol generation unit 52 comprises: an aerosol generation chamber 53 that receives supply of a carrier gas from a gas cylinder that stores the raw material powder, the gas cylinder not shown, to generate aerosol; a raw material supply pipe 54 that supplies generated aerosol to the film deposition unit 60; and a vibration exciter 55 that gives vibration of a frequency of 10 to 100 Hz to the aerosol generation chamber 53 and the aerosol therein. The film deposition unit 60 comprises: a film deposition chamber 62 that jets the aerosol onto the SiC single crystal substrate 20; a substrate holder 64 that is fixedly set up inside the film deposition chamber 62 to fix the SiC single crystal substrate 20; and an X-Y stage 63 that moves the substrate holder 64 in the X-axis and Y-axis directions. Further, the film deposition unit 60 comprises: a jet nozzle 66 that has a slit 67 formed at the tip and jets the aerosol onto the SiC single crystal substrate 20; and a vacuum pump 68 that reduces the pressure in the film deposition chamber 62. The jet nozzle 66 is attached to the tip of the raw material supply pipe 54.

The AD method is known to generate pores in a film or make a film into a green compact depending on the film deposition conditions. For example, the AD method is susceptible to the collision speed of the raw material powder onto the substrate, the particle size of the raw material powder, the aggregation state of the raw material powder in the aerosol, the jetting amount per unit time, and the like. The collision speed of the raw material powder onto the substrate is influenced by the differential pressure between the inside of the film deposition chamber 62 and the inside of the jet nozzle 66, the opening area of the jet nozzle, and the like. Therefore, to obtain a dense orientation precursor layer, these factors need to be controlled properly.

In the thermal CVD method, known film deposition apparatuses such as commercially available film deposition apparatuses can be utilized as a film deposition apparatus. The raw material gas is not particularly limited, and a silicon tetrachloride (SiCl₄) gas and a silane (SiH₄) gas as a supply source of Si, and a methane (CH₄) gas, a propane (C₃H₈) gas, and the like as a supply source of C can be used. The film deposition temperature is preferably 1000 to 2200°C, more preferably 1100 to 2000°C, and further preferably 1200 to 1900°C.

When film deposition is performed on the SiC single crystal substrate 20 using the thermal CVD method, it is known that epitaxial growth may occur on the SiC single crystal substrate 20 to form the rare earth-containing SiC substrate 30. However, the orientation precursor layer 40 is preferably not oriented, specifically is preferably an amorphous or non-oriented polycrystal, at the time of production, and it is preferred to allow rearrangement of the crystals to occur using a SiC single crystal as a seed crystal during the heat treatment process. The film deposition temperature, the flow rates of gases such as a Si source and a C source and the ratio thereof, the film deposition pressure, and the like are known to give influences in forming an amorphous or polycrystal layer on a SiC single crystal using the thermal CVD method. The influence of the film deposition temperature is large, and in view of forming an amorphous or polycrystal layer, the film deposition temperature is preferably lower, preferably lower than 1700°C, more preferably 1500°C or lower, and further preferably 1400°C or lower. However, when the film deposition temperature is too low, the film deposition rate itself is also lowered, and therefore the film deposition temperature is preferably higher in view of the film deposition rate.

When a previously produced green body is used as the orientation precursor layer 40, the green body can be produced by forming a raw material powder for the orientation precursor. For example, when press forming is used, the orientation precursor layer 40 is a press-formed green body. The press-formed green body can be produced by subjecting the raw material powder for the orientation precursor to press forming based on a known method and may be produced by, for example, putting the raw material powder into a metal mold and pressing the raw material powder at a pressure of preferably 100 to 400 kgf/cm², and more preferably 150 to 300 kgf/cm². The forming method is not particularly limited, and tape casting, extrusion forming, slip casting, and a doctor blade method, and optional combinations thereof can be used in addition to press forming. For example, when tape casting is used, additives such as a binder, a plasticizer, a dispersant, and a dispersion medium are appropriately added to the raw material powder to make a slurry, and this slurry is preferably allowed to pass through a slit-like thin ejection port to be ejected and formed into a sheet. The thickness of the green body formed into a sheet is not limited but is preferably 5 to 500 µm in view of handling. When a thick orientation precursor layer is necessary, a plurality of the sheet green bodies may be stacked into a desired thickness for use. A portion of these green bodies near the SiC single crystal substrate 20 is made into the rare earth-containing SiC substrate 30 by the subsequent heat treatment on the SiC single crystal substrate 20. In such a method, the green bodies need to be sintered in the heat treatment process, which will be described later. The rare earth-containing SiC substrate 30 is preferably formed after the green bodies are subjected to the process in which the green bodies are sintered and integrated as a polycrystalline substance with the SiC single crystal substrate 20. When the green bodies do not undergo a sintered state, epitaxial growth using a SiC single crystal as a seed may occur insufficiently. Therefore, the green body may contain an additive such as a sintering aid in addition to the SiC raw material.

### (b) Heat Treatment Process (see Figure 2(b))

In the heat treatment process, a laminate in which the orientation precursor layers 40 are laminated or placed on the SiC single crystal substrate 20 are subjected to heat treatment to generate the rare earth-containing SiC substrate 30. The heat treatment method is not particularly limited as long as epitaxial growth using the SiC single crystal substrate 20 as a seed occurs, and can be performed in a known heat treatment furnace such as a tube furnace or a hot plate. Not only heat treatment under normal pressure (pressless heat treatment) but also heat treatment under pressure such as hot pressing and HIP and a combination of the heat treatment under normal pressure and the heat treatment under pressure can be used. The atmosphere during the heat treatment can be selected from vacuum, nitrogen, and inert gas atmospheres. The heat treatment temperature is preferably 1700 to 2700°C. By increasing the temperature, the orientation precursor layer 40 is likely to grow using the SiC single crystal substrate 20 as a seed crystal while being oriented along the c-axis and the a-axis. Therefore, the heat treatment temperature is preferably 1700°C or higher, more preferably 1800°C or higher, further preferably 1900°C or higher, and particularly preferably 2200°C or higher. On the other hand, when the temperature is excessively high, there is a possibility that part of SiC is lost by sublimation or SiC is plastically deformed to cause a defect such as, for example, a warp. Therefore, the heat treatment temperature is preferably 2700°C or lower, and more preferably 2500°C or lower. However, the heat treatment conditions give an influence on the contents of rare earth element and B in the biaxially oriented SiC layer, and therefore it is preferred to appropriately control the conditions (for example, the heat treatment temperature and holding time). From such viewpoints, the heat treatment temperature is preferably 1900 to 2700°C, more preferably 2200 to 2600°C, and further preferably 2400 to 2500°C. The holding time is preferably 2 to 30 hours, and more preferably 4 to 20 hours. The heat treatment may be performed in a plurality of stages. For example, the heat treatment may be performed under the condition such as performing heat treatment in a nitrogen atmosphere at 1950°C for 3 hours and then performing heat treatment in an argon atmosphere at 2400°C for 3 hours. Even in such a case, the heat treatment temperature and the total holding time are preferably within the above ranges. Further, the heat treatment temperature and the holding time have a relationship with the thickness of the rare earth-containing SiC substrate 30 generated by epitaxial growth and can be appropriately adjusted.

However, a previously produced green body, when used as the orientation precursor layer 40, needs to be sintered during the heat treatment, and normal pressure firing at a high temperature, hot pressing, HIP, or a combination thereof is suitable. For example, when hot pressing is used, the surface pressure is preferably 50 kgf/cm² or higher, more preferably 100 kgf/cm² or higher, and further preferably 200 kgf/cm² or higher, and there is no upper limit in particular. In addition, the firing temperature is not particularly limited as long as sintering and epitaxial growth occur. However, the firing conditions give an influence on the contents of the rare earth element and B in the biaxially oriented SiC layer, and therefore it is preferred to appropriately control the conditions (for example, the firing temperature and holding time). From such viewpoints, the firing temperature is preferably 1700 to 2700°C. The holding time is preferably 2 to 18 hours. The atmosphere during the firing can be selected from vacuum, nitrogen, and inert gas atmospheres, or a mixed gas of nitrogen and an inert gas. As with those described above, the firing may be performed in a plurality of stages, and the firing temperature and the total holding time are preferably within the above ranges. The SiC powder which is a raw material may be composed of at least one of α-SiC and β-SiC, but is preferably composed of β-SiC. The SiC powder is preferably composed of SiC particles having an average particle size of 0.01 to 100 µm. The average particle size refers to an average value obtained when the powder is observed with a scanning electron microscope to measure the maximum sizes in a constant direction for 100 primary particles.

In the heat treatment process, the crystals in the orientation precursor layer 40 grow while being oriented along the c-axis and the a-axis from the crystal growth surface of the SiC single crystal substrate 20, and therefore the orientation precursor layer 40 is gradually changed into the rare earth-containing SiC substrate 30 from the crystal growth surface. The SiC composite substrate comprising the generated rare earth-containing SiC substrate 30 is such that breaking and cracks during the processing of the substrate are reduced. The reason for this is not clear, but it is considered that the presence of the rare earth element and B inside the substrate relaxes the strain in the SiC crystals, and as a result, breaking and cracks during the processing of the substrate are reduced.

### (c) Grinding Process (see Figure 2(c))

In the grinding process, the orientation precursor layer 40 left on the rare earth-containing SiC substrate 30 after the heat treatment process is ground away to expose the surface of the rare earth-containing SiC substrate 30, the exposed surface is subjected to polishing using diamond abrasive grains and is further subjected to a CMP (Chemical Mechanical Polishing) finish. Thus, the SiC composite substrate 10 is obtained.

The present invention is not limited to the above-described embodiments, and it is needless to say that that the present invention can be conducted in various aspects as long as they belong to the technical scope of the present invention. For example, in the above-described embodiment, only one layer of the rare earth-containing SiC substrate 30 is provided on the SiC single crystal substrate 20, but two or more layers may be provided. Specifically, by laminating the orientation precursor layer 40 on the rare earth-containing SiC substrate 30 of the SiC composite substrate 10, and performing heat treatment and grinding in the mentioned order, the rare earth-containing SiC substrate 30 as the second layer can be provided on the rare earth-containing SiC substrate 30.

### EXAMPLES

The present invention will be more specifically described by the following examples.

### Example 1

### (1) Production of Orientation Precursor Layer

In ethanol, 9.0% by weight of an yttrium oxide powder (volume-based D50 particle size: 0.1 µm) and 15.0% by weight of a boron carbide powder (volume-based D50 particle size: 0.5 µm) based on 100% by weight of a commercially available β-SiC fine powder (volume-based D50 particle size: 0.7 µm) were mixed with a ball mill using SiC balls for 24 hours, and a resultant mixture was dried to obtain a mixed powder (raw material powder). As a SiC single crystal layer, a commercially available SiC single crystal substrate (n-type 4H-SiC, diameter about 100 mm (4 inches), Si surface, (0001) plane, off angle 4°, thickness 0.35 mm, without an orientation flat) was provided, and the mixed powder was jetted onto the SiC single crystal substrate with the AD apparatus 50 shown in Figure 3 to form an AD film (orientation precursor layer).

Conditions for depositing the AD film were as follows. Firstly, N₂ was used as a carrier gas, and the film was deposited using a nozzle made of a ceramic and being such that a slit of 5 mm in long side × 0.4 mm in short side was formed. The condition for scanning the nozzle was as follows. The scan speed was set to 0.5 mm/s, the following scans were repeated: moving the nozzle 105 mm in a vertical and advancing direction with respect to the long side of the slit; moving the nozzle 5 mm in the long side direction of the slit; moving the nozzle 105 mm in a vertical and returning direction with respect to the long side of the slit; and moving the nozzle 5 mm in the long side direction of the slit and the opposite direction to the initial position, at the time when the nozzle was moved 105 mm from the initial position in the long side direction of the slit, scans were conducted in directions opposite to the previous directions to return the nozzle to the initial position, and this cycle was defined as one cycle, and this cycle was repeated up to 1200 cycles. The AD film thus formed had a thickness of about 120 µm.

### (2) Heat Treatment of Orientation Precursor Layer

The SiC single crystal substrate on which the AD film, which is the orientation precursor layer was formed was taken out of the AD apparatus, annealed in a N₂ atmosphere at 1950°C for 3 hours, and then annealed in an argon atmosphere at 2400°C for 3 hours. In other words, the orientation precursor layer was subjected to heat treatment to form a heat-treated layer.

### (3) Grinding and Polishing

The resultant heat-treated layer was subjected to surface grinding with a grinder (diamond wheel of Grit 1000 to 6000) such that the whole surface region of the resultant heat-treated layer was parallel to the bottom surface (the bottom surface of the SiC single crystal substrate). Subsequently, the whole surface region of the heat-treated layer was subjected to polishing using diamond abrasive grains (whose grain sizes are 3.0 µm, 1.0 µm, 0.5 µm, and 0.1 µm respectively) in descending order of grain size, and then subjected a chemical mechanical polishing (CMP) finish into a targeted thickness and surface state to complete the grinding and the polishing. Thus, a SiC substrate was obtained.

### (4) Evaluation of SiC Substrate

### (4-1) Rate of Occurrence of Breaking and Crack after Polishing

An industrial microscope (manufactured by NIKON CORPORATION, ECLIPSE, LV150N) was used with an eye lens whose magnification was 10 times and an objective lens whose magnification was 5 times. When the whole surface of the SiC substrate was observed in a polarization mode and a differential interference mode and breaking or a crack was confirmed to be present, the substrate was regarded as a substrate where breaking or a crack is present. At this time, with respect to breaking and a crack, only those having a length of 100 µm or longer were counted as breaking and a crack. Among 100 sheets of SiC substrate produced under the same conditions as the SiC substrate produced in the manner as described above, the rate (%) of occurrence of breaking and a crack was calculated by determining the number of SiC substrates where breaking and a crack whose lengths are 100 µm or longer are present.

### (4-2) Contents of Rare Earth Element and B in Heat-Treated Layer (Biaxially Oriented SiC Layer)

After the evaluation of (4-1), one out of 100 sheets of produced SiC substrates was taken out, and the polished surface of the SiC substrate was subjected to dynamic secondary ion mass spectroscopy (D-SIMS). As an analyzer for the rare earth element (Y in the present example) and B, IMS-7f manufactured by CAMECA was used to conduct measurement using O₂⁺ as a primary ion species at an acceleration voltage of 11.0 kV. This measurement was conducted at 10 points on the polished surface of the heat-treated layer (biaxially oriented SiC layer). In each point among these 10 points, the maximum value of the concentration of the rare earth element and the maximum value of the concentration of B were measured to calculate the average values of respective maximum values in these 10 points. These average values were defined as the concentration C_{RE} (atoms/cm³) of the rare earth element and the concentration C_{B} (atoms/cm³) of B in the biaxially oriented SiC layer. Further, the ratio of the concentration C_{B} of B to the concentration C_{RE} of the rare earth element, C_{B}/C_{RE} was also determined. Obtained results are shown in Table 1.

### (5) Grinding and Polishing

After the evaluation of (4-2), the SiC substrate was cut in a direction orthogonal to the plate surface such that the cutting plane passed through the central portion of the substrate. The cut sample was subjected to lapping using diamond abrasive grains to make the section smooth, and the section was mirror-finished by chemical mechanical polishing (CMP).

### (6) Evaluation of SiC Substrate

### (6-1) Biaxial Orientation Property

Inverse pole figure mapping was measured using the EBSD (Electron Back Scatter Diffraction Patterns) method for the surface (plate surface) and section orthogonal to the plate surface of the heat-treated layer produced in (5) under the following conditions to find the tilt angle distribution to be 0.01° or less for both the approximate normal direction and the approximate plate surface direction, and therefore the heat-treated layer was determined to be a biaxially oriented SiC layer oriented along the c-axis and the a-axis.

### <Conditions for EBSD Measurement>

- Acceleration voltage: 15 kV
- Spot intensity: 70
- Working distance: 22.5 mm
- Step size: 0.5 µm
- Tilt angle of sample: 70°
- Measurement program: Aztec (version 3.3)

### Example 2 (Comparison)

A SiC substrate was produced and evaluated as in Example 1 except that a raw material powder containing 10.0% by weight of the yttrium oxide powder and 35.0% by weight of the boron carbide powder based on 100% by weight of the β-SiC powder was used in (1). The resultant heat-treated layer was confirmed to be a biaxially oriented SiC layer. The results were as shown in Table 1.

### Example 3

A SiC substrate was produced and evaluated as in Example 1 except that a raw material powder containing 10.0% by weight of the yttrium oxide powder and 34.0% by weight of the boron carbide powder based on 100% by weight of the β-SiC powder was used in (1). The resultant heat-treated layer was confirmed to be a biaxially oriented SiC layer. The results were as shown in Table 1.

### Example 4

A SiC substrate was produced and evaluated as in Example 1 except that a raw material powder containing 10.0% by weight of the yttrium oxide powder and 30.0% by weight of the boron carbide powder based on 100% by weight of the β-SiC powder was used in (1). The resultant heat-treated layer was confirmed to be a biaxially oriented SiC layer. The results were as shown in Table 1.

### Example 5

A SiC substrate was produced and evaluated as in Example 1 except that a raw material powder containing 11.0% by weight of the yttrium oxide powder and 30.0% by weight of the boron carbide powder based on 100% by weight of the β-SiC powder was used in (1). The resultant heat-treated layer was confirmed to be a biaxially oriented SiC layer. The results were as shown in Table 1.

### Example 6

A SiC substrate was produced and evaluated as in Example 1 except that a raw material powder containing 10.0% by weight of the yttrium oxide powder and 15.0% by weight of the boron carbide powder based on 100% by weight of the β-SiC powder was used in (1). The resultant heat-treated layer was confirmed to be a biaxially oriented SiC layer. The results were as shown in Table 1.

### Example 7

A SiC substrate was produced and evaluated as in Example 1 except that a raw material powder containing 6.0% by weight of the yttrium oxide powder and 15.0% by weight of the boron carbide powder based on 100% by weight of the β-SiC powder was used in (1). The resultant heat-treated layer was confirmed to be a biaxially oriented SiC layer. The results were as shown in Table 1.

### Example 8

A SiC substrate was produced and evaluated as in Example 1 except that a raw material powder containing 5.0% by weight of the yttrium oxide powder and 15.0% by weight of the boron carbide powder based on 100% by weight of the β-SiC powder was used in (1). The resultant heat-treated layer was confirmed to be a biaxially oriented SiC layer. The results were as shown in Table 1.

### Example 9

A SiC substrate was produced and evaluated as in Example 1 except that a raw material powder containing 2.0% by weight of the yttrium oxide powder and 15.0% by weight of the boron carbide powder based on 100% by weight of the β-SiC powder was used in (1). The resultant heat-treated layer was confirmed to be a biaxially oriented SiC layer. The results were as shown in Table 1.

### Example 10

A SiC substrate was produced and evaluated as in Example 1 except that a raw material powder containing 1.0% by weight of the yttrium oxide powder and 15.0% by weight of the boron carbide powder based on 100% by weight of the β-SiC powder was used in (1). The resultant heat-treated layer was confirmed to be a biaxially oriented SiC layer. The results were as shown in Table 1.

### Example 11

A SiC substrate was produced and evaluated as in Example 1 except that a raw material powder containing 7.0% by weight of the yttrium oxide powder and 21.0% by weight of the boron carbide powder based on 100% by weight of the β-SiC powder was used in (1). The resultant heat-treated layer was confirmed to be a biaxially oriented SiC layer. The results were as shown in Table 1.

### Example 12

A SiC substrate was produced and evaluated as in Example 1 except that a raw material powder containing 7.0% by weight of the yttrium oxide powder and 19.0% by weight of the boron carbide powder based on 100% by weight of the β-SiC powder was used in (1). The resultant heat-treated layer was confirmed to be a biaxially oriented SiC layer. The results were as shown in Table 1.

### Example 13

A SiC substrate was produced and evaluated as in Example 1 except that a raw material powder containing 7.0% by weight of the yttrium oxide powder and 9.0% by weight of the boron carbide powder based on 100% by weight of the β-SiC powder was used in (1). The resultant heat-treated layer was confirmed to be a biaxially oriented SiC layer. The results were as shown in Table 1.

### Example 14

A SiC substrate was produced and evaluated as in Example 1 except that a raw material powder containing 7.0% by weight of the yttrium oxide powder and 8.0% by weight of the boron carbide powder based on 100% by weight of the β-SiC powder was used in (1). The resultant heat-treated layer was confirmed to be a biaxially oriented SiC layer. The results were as shown in Table 1.

### Example 15

A SiC substrate was produced and evaluated as in Example 1 except that a raw material powder containing 7.0% by weight of the yttrium oxide powder and 7.0% by weight of the boron carbide powder based on 100% by weight of the β-SiC powder was used in (1). The resultant heat-treated layer was confirmed to be a biaxially oriented SiC layer. The results were as shown in Table 1.

### Example 16

A SiC substrate was produced and evaluated as in Example 1 except that a raw material powder containing 7.0% by weight of the yttrium oxide powder and 6.0% by weight of the boron carbide powder based on 100% by weight of the β-SiC powder was used in (1). The resultant heat-treated layer was confirmed to be a biaxially oriented SiC layer. The results were as shown in Table 1.

### Example 17

A SiC substrate was produced and evaluated as in Example 1 except that a raw material powder containing 15.0% by weight of the yttrium oxide powder and 20.0% by weight of the boron carbide powder based on 100% by weight of the β-SiC powder was used in (1). The resultant heat-treated layer was confirmed to be a biaxially oriented SiC layer. The results were as shown in Table 1.

### Example 18

A SiC substrate was produced and evaluated as in Example 1 except that a raw material powder containing 16.0% by weight of the yttrium oxide powder and 20.0% by weight of the boron carbide powder based on 100% by weight of the β-SiC powder was used in (1). The resultant heat-treated layer was confirmed to be a biaxially oriented SiC layer. The results were as shown in Table 1.

### Example 19

A SiC substrate was produced and evaluated as in Example 1 except that a raw material powder containing 25.0% by weight of the yttrium oxide powder and 20.0% by weight of the boron carbide powder based on 100% by weight of the β-SiC powder was used in (1). The resultant heat-treated layer was confirmed to be a biaxially oriented SiC layer. The results were as shown in Table 1.

### Example 20 (Comparison)

A SiC substrate was produced and evaluated as in Example 1 except that a raw material powder containing 26.0% by weight of the yttrium oxide powder and 20.0% by weight of the boron carbide powder based on 100% by weight of the β-SiC powder was used in (1). The resultant heat-treated layer was confirmed to be a biaxially oriented SiC layer. The results were as shown in Table 1.

### Example 21

A SiC substrate was produced and evaluated as in Example 1 except that a raw material powder containing 9.0% by weight of the yttrium oxide powder and 15.0% by weight of the boron carbide powder based on 100% by weight of an α-SiC powder (volume-based D50 particle size: 0.7 µm) was used in (1). The resultant heat-treated layer was confirmed to be a biaxially oriented SiC layer. The results were as shown in Table 1.

### Example 22

A SiC substrate was produced and evaluated as in Example 1 except that a raw material powder containing 9.0% by weight of a cerium oxide powder (volume-based D50 particle size: 0.5 µm) and 15.0% by weight of the boron carbide powder based on 100% by weight of the β-SiC powder was used in (1). The resultant heat-treated layer was confirmed to be a biaxially oriented SiC layer. The results were as shown in Table 1.

### [Table 1]

**Table 1**

| | Biaxially oriented SiC layer | | | | | Rare earth-containing SiC substrate |
|---|---|---|---|---|---|---|
| | Concentration (atoms/cm³) of each element | | | Concentration ratio between elements | | Rate (%) of occurrence of breaking and cracks |
| | C_{RE} | | C_{B} | C_{B}/C_{RE} | | |
| | Y | Ce | B | B/Y | B/Ce | |
| Ex. 1 | 8.7×10¹⁵ | - | 1.0×10¹⁶ | 1.1×10⁰ | - | 2 |
| Ex. 2* | 9.8×10¹⁵ | - | 1.1×10²¹ | 1.1×10⁵ | - | 86 |
| Ex. 3 | 1.1×10¹⁶ | - | 9.7×10²⁰ | 8.8×10⁴ | - | 42 |
| Ex. 4 | 1.2×10¹⁶ | - | 1.3×10²⁰ | 1.1×10⁴ | - | 43 |
| Ex. 5 | 1.4×10¹⁶ | - | 1.3×10²⁰ | 9.3×10³ | - | 26 |
| Ex. 6 | 9.9×10¹⁵ | - | 1.2×10¹⁶ | 1.2×10⁰ | - | 14 |
| Ex. 7 | 1.6×10¹⁴ | - | 1.1×10¹⁶ | 6.9×10¹ | - | 3 |
| Ex. 8 | 9.9×10¹³ | - | 1.0×10¹⁶ | 1.0×10² | - | 10 |
| Ex. 9 | 3.2×10¹³ | - | 1.2×10¹⁶ | 3.8×10² | - | 9 |
| Ex. 10 | 2.8×10¹³ | - | 1.1×10¹⁶ | 3.9×10² | - | 15 |
| Ex. 11 | 4.2×10¹⁴ | - | 2.8×10¹⁸ | 6.7×10³ | - | 13 |
| Ex. 12 | 4.1×10¹⁴ | - | 7.7×10¹⁷ | 1.9×10³ | - | 3 |
| Ex. 13 | 4.4×10¹⁴ | - | 1.3×10¹⁵ | 3.0×10⁰ | - | 1 |
| Ex. 14 | 4.1×10¹⁴ | - | 9.5×10¹⁴ | 2.3×10° | - | 11 |
| Ex. 15 | 4.3×10¹⁴ | - | 4.7×10¹⁴ | 1.1×10⁰ | - | 8 |
| Ex. 16 | 4.0×10¹⁴ | - | 4.4×10¹⁴ | 1.1×10⁰ | - | 16 |
| Ex. 17 | 1.1×10¹⁸ | - | 1.2×10¹⁸ | 1.1×10⁰ | - | 25 |
| Ex. 18 | 1.2×10¹⁸ | - | 1.1×10¹⁸ | 9.2×10⁻¹ | - | 45 |
| Ex. 19 | 9.8×10¹⁹ | - | 1.3×10¹⁸ | 1.3×10⁻² | - | 41 |
| Ex. 20* | 1.4×10²⁰ | - | 1.2×10¹⁸ | 8.6×10⁻³ | - | 95 |
| Ex. 21 | 8.5×10¹⁵ | - | 1.1×10¹⁶ | 1.3×10⁰ | - | 2 |
| Ex. 22 | - | 8.6×10¹⁵ | 1.2×10¹⁶ | - | 1.4×10⁰ | 4 |

| | | | | | | |
|---|---|---|---|---|---|---|
| * indicates a comparative example. | | | | | | |

It was found from Examples 1, 3 to 19, 21, and 22 that a decrease in breaking and cracks during the processing of the SiC substrate can be achieved by making the ratio of the concentration C_{B} of B to the concentration C_{RE} of the rare earth element in the biaxially oriented SiC layer, C_{B}/C_{RE}, 1.0 × 10⁻² to 1.0 × 10⁵. On the other hand, it was found from Examples 2 and 20 (comparison) that when the ratio C_{B}/C_{RE} is out of the above range, breaking and cracks of the SiC substrate are increased. In addition, it was found that when the ratio C_{B}/C_{RE} is 1.0 × 10⁰ to 1.0 × 10⁴, breaking and cracks are decreased more. It was found that when C_{RE} is 3.0 × 10¹³ to 9.0 × 10¹⁵ atoms/cm³, or further 1.0 × 10¹⁴ to 9.0 × 10¹⁵ atoms/cm³, or when C_{B} is 4.5 × 10¹⁴ to 1.0 × 10¹⁸ atoms/cm³, or further 1.0 × 10¹⁵ to 1.0 × 10¹⁸ atoms/cm³, it is more effective for decreasing in breaking and cracks.

## Claims

1. A rare earth-containing SiC substrate comprising a biaxially oriented SiC layer wherein a ratio of a concentration C_{B} of B to a concentration C_{RE} of a rare earth element, C_{B}/C_{RE}, is 1.0 × 10⁻² to 1.0 × 10⁵.

2. The rare earth-containing SiC substrate according to claim 1, wherein the ratio C_{B}/C_{RE} is 1.0 × 10⁰ to 1.0 × 10⁴.

3. The rare earth-containing SiC substrate according to claim 1 or 2, wherein the concentration C_{RE} of the rare earth element is 3.0 × 10¹³ to 9.0 × 10¹⁵ atoms/cm³.

4. The rare earth-containing SiC substrate according to any one of claims 1 to 3, wherein the concentration C_{RE} of the rare earth element is 1.0 × 10¹⁴ to 9.0 × 10¹⁵ atoms/cm³.

5. The rare earth-containing SiC substrate according to any one of claims 1 to 4, wherein the concentration C_{B} of B is 4.5 × 10¹⁴ to 1.0 × 10¹⁸ atoms/cm³.

6. The rare earth-containing SiC substrate according to any one of claims 1 to 5, wherein the concentration C_{B} of B is 1.0 × 10¹⁵ to 1.0 × 10¹⁸ atoms/cm³.

7. The rare earth-containing SiC substrate according to any one of claims 1 to 6, wherein the rare earth element is Y and/or Ce.

8. The rare earth-containing SiC substrate according to any one of claims 1 to 7, wherein the rare earth element is Y.

9. The rare earth-containing SiC substrate according to any one of claims 1 to 8, wherein the biaxially oriented SiC layer is oriented in the c-axis direction and the a-axis direction.

10. A SiC composite substrate comprising:
a SiC single crystal substrate; and
the rare earth-containing SiC substrate according to any one of claims 1 to 9 on the SiC single crystal substrate.
